(19) Europäisches Patentamt

European Patent Office

Office européen des brevets

(11) Veröffentlichungsnummer: **0 142 114
B1**

(12) **EUROPÄISCHE PATENTSCHRIFT**

(45) Veröffentlichungstag der Patentschrift: **16.01.91**

(21) Anmeldenummer: **84113336.6**

(22) Anmeldetag: **06.11.84**

(51) Int. Cl.⁵: **H 01 L 31/18,** H 01 L 31/02,
H 01 L 21/385

(54) Verfahren zum Herstellen einer Solarzelle.

(30) Priorität: **11.11.83 DE 3340874**

(43) Veröffentlichungstag der Anmeldung:
**22.05.85 Patentblatt 85/21**

(45) Bekanntmachung des Hinweises auf die
Patenterteilung:
**16.01.91 Patentblatt 91/03**

(84) Benannte Vertragsstaaten:
**FR GB IT NL**

(56) Entgegenhaltungen:
**EP-A-0 022 956         US-A-4 101 351
EP-A-0 024 057    ·    US-A-4 278 831
EP-A-0 054 737         US-A-4 331 703
FR-A-1 297 206         US-A-4 377 901**

(73) Patentinhaber: **TELEFUNKEN electronic GmbH
Theresienstrasse 2
D-7100 Heilbronn (DE)**

(72) Erfinder: **Schmidt, Wilfried, Dipl.-Phys.
Schillerstrasse 11
D-7129 Talheim (DE)**

(74) Vertreter: **Maute, Hans-Jürgen, Dipl.-Ing.
TELEFUNKEN electronic GmbH
Theresienstrasse 2
D-7100 Heilbronn (DE)**

(56) Entgegenhaltungen:
**JOURNAL OF THE ELECTROCHEMICAL
SOCIETY: SOLID-STATE SCIENCE AND
TECHNOLOGY, Band 127, Nr. 11, November
1980, Seiten 2478-2481, Princeton, US; B.E.
YOLDAS: "Diffusion of dopants from optical
coatings and single step formation of
antireflective coating and P-N junction in
photovoltaic cells"**

Courier Press, Leamington Spa, England.

**EP 0 142 114 B1**

(56) Entgegenhaltungen:
PATENT ABSTRACTS OF JAPAN, Band 7, Nr. 94
(E-171)1239r, 20. April 1983 & JP-A-58-18974

JOURNAL OF APPLIED PHYSICS, Band 52, Nr. 7,
Juli 1981, Seiten 4821-4824, American Institute
of Physics, New York, US; G.C. JAIN et al.:
"Fabrication of P+N-N-silicon solar cells by
simultaneous diffusion of boron and
phosphorus into silicon through silicon dioxide"

SOLID STATE ELECTRONICS, Band 24, 1981,
Seiten 415-420, Oxford, GB; J. DEL ALAMO et
al.: "Operating limits of Al-alloyed high-low
junctions for BSF solar cells"

JOURNAL OF THE ELECTROCHEMICAL
SOCIETY: ELECTROCHEMICAL SCIENCE AND
TECHNOLOGY, Band 124, Nr. 9, 1977, Seiten
1409-1413, Princeton, US; T.C. CHANDLER et
al.: "The properties of silica diffusion sources
under oxidizing ambient conditions and their
application to solar cell fabrication"

## Beschreibung

Die Erfindung betrifft ein Verfahren zum Herstellen einer Solarzelle mit einem pn-Übergang und einer leitfähigen Antireflexschicht, bei dem der pn-Übergang durch Diffusion von Störstellen aus einer Dotierschicht hergestellt wird, bei dem auf einen Halbleiterkörper eine erste Schicht aufgebracht wird, die als Diffusionsquelle für die Herstellung des pn-Überganges sowie zur Dotierung der Antireflexschicht dient, bei dem auf die erste Schicht eine zweite Schicht für die Herstellung der Antireflexschicht aufgebracht wird, und bei dem ein Temperprozeß durchgeführt wird, bei dem der pn-Übergang hergestellt, aus den beiden Schichten die Antireflexschicht gebildet und die Antireflexschicht dotiert und dadurch gut leitfähig wird.

Ein derartiges Verfahren ist aus der US—A 4 278 831 bekannt. Aus der US—A 4 377 901 ist ein Verfahren zum Herstellen einer Solarzelle bekannt, wobei auf der Rückseite im Oberflächenbereich des Halbleiterkörpers eine Halbleiterzone vom Leitungstyp des Halbleiterkörpers hergestellt wird, deren Leitfähigkeit größer ist als die des Halbleiterkörpers.

Der Erfindung liegt die Aufgabe zugrunde, bei einem Verfahren der eingangs erwähnten Art geeignete Materialien für die Antireflexschicht anzugeben. Diese Aufgabe wird bei einem Verfahren der eingangs erwähnten Art durch die kennzeichnenden Merkmale des Anspruchs 1 nach der Erfindung gelöst.

Gemäß einer Weiterbildung der Erfindung wird auf der Rückseite der Solarzelle im Oberflächenbereich des Halbleiterkörpers eine Halbleiterzone vom Leitungstyp des Halbleiterkörpers hergestellt, deren Leitfähigkeit größer ist als die des Halbleiterkörpers. Auf dieser Halbleiterzone wird eine leitfähige Antireflexschicht hergestellt, so daß auch auf der Rückseite der Solarzelle eine leitfähige Antireflexschicht vorhanden ist.

Die Herstellung der Halbleiterzone vom Leitungstyp des Halbleiterkörpers sowie der Antireflexschicht erfolgt beispielsweise in analoger Weise zur Herstellung des pn-Überganges und der Antireflexschicht auf der Vorderseite dadurch, daß auf dir Rückseite des Halbleiterkörpers eine dritte Schicht aufgebracht wird, die im wesentlichen als Diffusionsquelle zur Herstellung der Halbleiterzone vom Leitungstyp des Halbleiterkörpers sowie außerdem zur Dotierung der Antireflexschicht dient. Auf diese dritte Schicht wird eine vierte Schicht aufgebracht, die mit der dritten Schicht die Antireflexschicht ergibt. Dann erfolgt ein Temperprozeß, bei dem der pn-Übergang auf der Vorderseite und der Übergang auf der Rückseite entstehen und außerdem aus den beiden Schichten auf der Vorderseite und auf der Rückseite die leitfähigen Antireflexschichten gebildet werden. Oder es erfolgt ein separater Temperschritt, bei dem der Übergang auf der Rückseite entsteht und außerdem aus den beiden Schichten die leitfähige Antireflexschicht auf der Rückseite gebildet wird.

Die erste und die dritte Schicht werden beispielsweise durch Aufschleudern, Tauchne, Aufsprühen, Siebdrucken oder durch Aufrollen aufgebracht. Die zweite und die vierte Schicht werden beispielsweise durch Aufdampfen, chemisches Abscheiden aus der Gasphase oder durch Siebdrucken hergestellt.

Die Erfindung hat den wesentlichen Vorteil, daß leitfähige Antireflexschichten auf relativ rauhen Halbleiteroberflächen hergestellt werden können, so daß man auf ein kostspieliges Polieren der Halbleiteroberfläche verzichten kann. Ein weiterer Vorteil der Erfindung besteht darin, daß die Dotierstoffe, die zur Herstellung des pn-Überganges der Solarzelle dienen und außerdem auch die Antireflexschicht leitend machen, an einer Ausdiffusion gehindert werden und dadurch Querdiffusion verhindert wird. Außerdem ist es möglich, verschiedene Verfahren zur Aufbringung der im wesentlichen dotierenden Schicht und der im wesentlichen die Antireflexschicht bildenden Schicht anzuwenden. Auch können der Dotierstoff bzw. dessen Verbindung in der Dotierschicht, der Antireflexschichtbildner sowie die Trägerstoffe frei gewählt werden, ohne daß chemische Reaktionen, die zu Ausfällungen oder anderen unerwünschten Reaktionen führen, eintreten. Dadurch ist eine Vielzahl der bisher vorhandenen Technologien, abgesehen von eventuellen notwendigen Trocken- oder Ausheizschritten weiterhin anwendbar bzw. kombinierbar. Da die Antireflexschicht beim Verfahren nach der Erfindung leitend gemacht wird, ermöglicht die Erfindung das Anbringen von Kontakten auf der Antireflexschicht. Dadurch verhindert das erfindungsgemäße Verfahren, daß der pn-Übergang bei der Kontaktherstellung kurzgeschlossen wird.

Gemäß einer Weiterbildung der Erfindung wird auf der Rückseite der Solarzelle im Oberflächenbereich des Halbleiterkörpers eine Halbleiterzone vom Leitungstyp des Halbleiterkörpers hergestellt, deren Leitfähigkeit größer ist als die des Halbleiterkörpers. Auf dieser Halbleiterzone wird eine leitfähige Antireflexschicht hergestellt, so daß auch auf der Rückseite der Solarzelle eine leitfähige Antireflexschicht vorhanden ist.

Die Herstellung der Halbleiterzone vom Leitungstyp des Halbleiterkörpers sowie der Antireflexschicht erfolgt beispielsweise in analoger Weise zur Herstellung des pn-Überganges und der Antireflexschicht auf der Vorderseite dadurch, daß auf die Rückseite des Halbleiterkörpers eine dritte Schicht aufgebracht wird, die im wesentlichen als Diffusionsquelle zur Herstellung der Halbleiterzone vom Leitungstyp des Halbleiterkörpers sowie außerdem zur Dotierung der Antireflexschicht dient. Auf diese dritte Schicht wird eine vierte Schicht aufgebracht, die mit der dritten Schicht die Antireflexschicht ergibt. Dann erfolgt ein Temperprozeß, bei dem der pn-Übergang auf der Vorderseite und der Übergang auf der Rückseite entstehen und außerdem aus den beiden Schichten auf der Vorderseite und auf der Rückseite die leitfähigen Antireflexschichten gebildet werden. Oder es erfolgt ein separater Temperschritt, bei dem der Übergang auf der Rückseite entsteht und außerdem aus den beiden Schichten die leitfähige Antireflexschicht auf der Rückseite gebildet wird.

Die erste Schicht besteht aus dotiertem $SiO_2$, $Ta_2O_5$ oder $TiO_x$ oder deren Kombinationen. Die zweite Schicht besteht aus $SiO_2$, $Ta_2O_5$ oder $TiO_x$ oder deren Kombinationen.

Die dritte Schicht besteht beispielsweise aus dotiertem $SiO_2$, $Ta_2O_5$ oder $TiO_x$ oder deren Kombinationen. Für die vierte Schicht empfiehlt sich ebenfalls die Verwendung von $SiO_2$, $Ta_2O_5$ oder $TiO_x$ oder deren Kombinationen. Die erste und die dritte Schicht werden beispielsweise durch Aufschleudern, Tauchen, Aufsprüchen, Siebdrucken oder durch Aufrollen aufgebracht. Die zweite und die vierte Schicht werden beispielsweise durch Aufdampfen, chemisches Abscheiden aus der Gasphase oder durch Siebdrucken hergestellt.

Die Dotierstoffkonzentration in der ersten und dritten Schicht wird möglichst groß gewählt. Außerdem sollen diese Schichten möglichst dünn ausgebildet sein.

Die zweite und die vierte Schicht werden vorzugsweise so dick ausgebildet, daß die optische Gesamtdicke der ersten und zweiten Schicht sowie der dritten und vierten Schicht 1/4 der Wellenlänge des Reflexionsminimums beträgt.

Die Erfindung wird im folgenden an einem Ausführungsbeispiel erläutert.

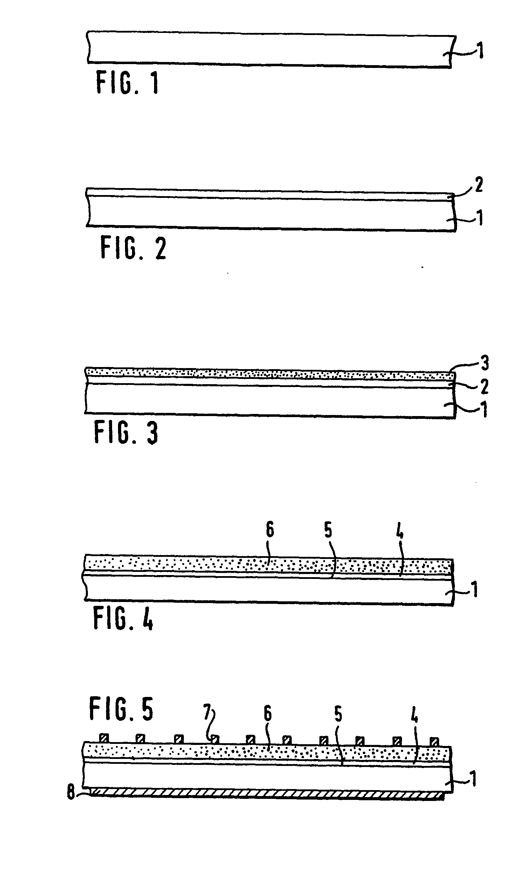

Zur Herstellung einer Solarzelle nach der Erfindung geht man gemäß der Figur 1 beispielsweise von einem Halbleiterkörper 1 aus Silicium vom p-Leitungstyp aus, der beispielsweise einen spezifischen Widerstand von 0,1—10 Ohmcm aufweist. Auf den Halbleiterkörper 1 wird gemäß der Figur 2 eine Schicht 2 als Dotierfilm aufgebracht, die als Diffusionsquelle zur Herstellung des pn-Überganges der Solarzelle dient. Da zur Herstellung des pn-Überganges Störstellen erforderlich sind, die im Halbleiterkörper eine Halbleiterzone erzeugen, deren Leitungstyp dem des Halbleiterkörpers entgegengesetzt ist, enthält die Dotierschicht 2 bei Verwendung eines Halbleiterkörpers vom p-Leitungstyp Störstellen wie Phosphor oder Arsen, die den n-Leitungstyp erzeugen.

Die Dotierschicht 2 besteht aus $SiO_2$ oder $TiO_x$, welches mit Störstellen (z. B. Phosphor oder Arsen) versetzt ist. Die Dotierschicht 2 ist so auszubilden, daß die Dotierstoffkonzentration in ihr so hoch wie möglich ist (größer als $2.10^{21}$ pro $cm^3$), während umgekehrt die Konzentration der restlichen Bestandteile, die als Trägermaterial dienen (z. B. Titan- und Siliciumverbindungen), möglichst gering sein soll.

Der Dotierfilm 2 wird möglichst dünn aufgebracht bzw. der Lösungsmittelanteil wird so hoch gewählt, daß für den Diffusionsprozeß zur Herstellung des pn-Überganges zwar ausreichend Dotierstoff zur Verfügung steht, andererseits aber die beim Diffusionstemperprozeß entstehende Glasmatrix ($SiO_2$, $TiO_x$) möglichst dünn ausfällt. Die Dotierschicht 2 wird deshalb so dünn ausgebildet, damit relativ hohe Dickenschwankungen der Schicht 2, die bei relativ unebenen Halbleiteroberflächen unvermeidbar sind, sich möglichst wenig auf die optische Gesamtdicke der Antireflexschicht auswirken, die aus einer auf die Schicht 2 noch aufzubringenden Schicht und der Schicht 2 gebildet wird. Durch eine entsprechend dünne Bemessung der Dotierschicht 2 läßt sich somit selbst bei einer relativ unebenen Halbleiteroberfläche eine relativ gleichmäßig dicke Antireflexschicht erzielen. Das Aufbringen der Dotierschicht 2 erfolgt beispielsweise durch Aufschleudern, Aufsprühen, Tauchen, Siebdrucken oder Aufrollen eines Dotierfilms.

Vor dem Aufbringen der Schicht 3 kann eventuell ein Vortrocknen bzw. Ausheizen der Schicht 2 bei 200—600°C erfolgen.

Das Aufbringen einer Schicht 3 auf die Schicht 2, die beide zusammen die Antireflexschicht bilden, zeigt die Figur 3. Die Schicht 3 wird beispielsweise durch Aufdampfen, durch chemisches Abscheiden aus der Gasphase nach dem sogenannten CVD-Verfahren oder durch Siebdruckken hergestellt. Die Schicht 3 wird so dick bemessen, daß die aus den Schichten 2 und 3 entstehende Antireflexschicht 6 eine optische Gesamtdicke von 1/4 der Wellenlänge des gewünschten Reflexionsminimums aufweist.

Nach dem Herstellen der Schicht 3 erfolgt ein Temperprozeß, bei dem die Störstellen aus der Dotierschicht 2 in den Halbleiterkörper 1 diffundieren und dort gemäß der Figur 4 eine Halbleiterzone 4 erzeugen, deren Leitungstyp dem des Halbleiterkörpers 1 entgegengesetzt ist und die deshalb mit dem Halbleiterkörper 1 einen pn-Übergang 5 bildet. Bei dem Temperprozeß, der beispielsweise bei einer Temperatur von 850 bis 1000°C stattfindet und 1 Stunde dauert, verschmelzen die beiden Schichten 2 und 3 zu einer gemeinsamen leitfähigen Antireflexschicht 6 (Figur 4). Dabei verhindert die Schicht 3, daß relevante Konzentrationen des Dotierstoffes nach außen gelangen. Die Dotierstoffe diffundieren beim Temperprozeß jedoch nicht nur in den Halbleiterkörper 1, sondern auch in die Antireflexschicht 6 und sorgen dafür, daß die aus den Schichten 2 und 3 gebildete Gesamt-Antireflexschicht 6 leitend wird.

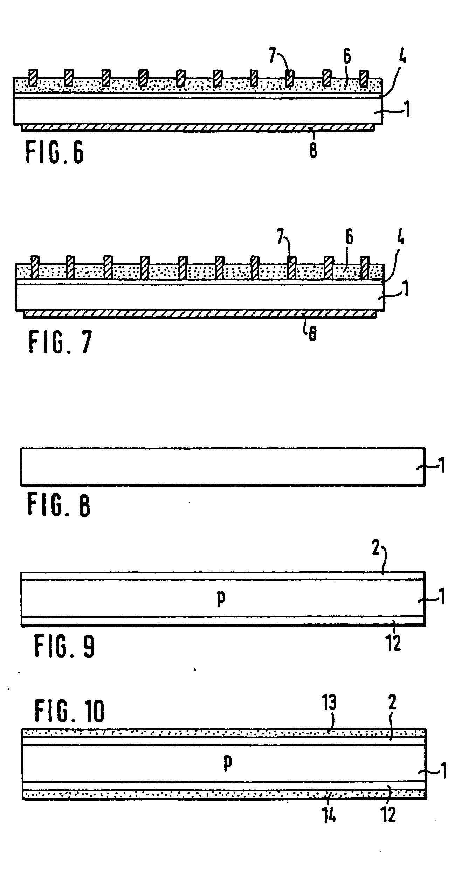

Da die Antireflexschicht 6 nach der Temperbehandlung leitend ist, genügt es, den Vorderseitenkontakt 7 gemäß der Figur 5 lediglich auf die Oberfläche der Antireflexschicht 6 aufzubringen. Der Vorderseitenkontakt 7 kann jedoch gemäß der Figur 6 auch teilweise oder gemäß der Figur 7 ganz in die Antireflexschicht 6 einlegiert werden. Auf der Rückseite des Halbleiterkörpers 1 wird der Rückseitenkontakt 8 aufgebracht, der im Ausführungsbeispiel (Figur 5 bis 7) ganzflächig ausgebildet ist.

Die Figuren 8 bis 12 zeigen ein Ausführungsbeispiel der Erfindung, bei dem eine Solarzelle entsteht, die sich von der Solarzelle der Figur 7 dadurch unterscheidet, daß zwei Übergänge vorhanden sind, und zwar auf der Vorderseite der pn-Übergang 5 der Solarzelle und auf der Rückseite der Solarzelle ein Übergang 9, der durch Halbleiterzonen vom gleichen Leitungstyp, jedoch unterschiedlicher Leitfähigkeit gebildet wird. Im Ausführungsbeispiel ist der Übergang 9 ein $p^+p$-Übergang, dessen ein Halbleiterzone 10 ebenso wie die Halbleiterzone 4 von einer Antireflexschicht (11) bedeckt ist.

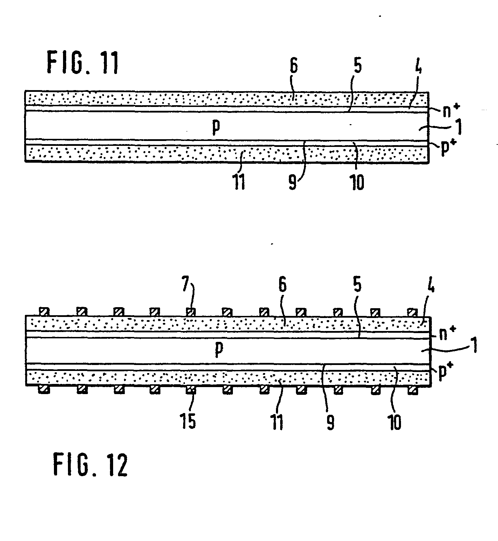

Die Herstellung des $p^+p$-Überganges 9 und der auf der $P^+$-Zone 10 befindlichen Antireflexschicht erfolgt in völlig analoger Weise zur Herstellung des pn-Überganges 5 und der Antireflexschicht 6 auf der Vorderseite der Solarzelle. Zur Herstellung der Solarzelle der Figur 12 geht man gemäß der Figur 8 wieder von einem Halbleiterkörper 1 vom p-Leitungstyp aus, bringt gemäß der Figur 9 auf die Vorderseite wieder einen (mit n-Störstellen versetzten) Dotierfilm 2 auf und versieht—im Gegensatz zum ersten Ausführungsbeispiel der Figuren 1 bis 7—auch die Rückseite mit einem Dotierfilm (12), der jedoch im Gegensatz zum Dotierfilm 2 auf der Vorderseite p-Störstellen aufweist. Anschließend wird gemäß der Figur 10 auf beide Dotierfilme (2, 12) eine zur Herstellung der Antireflexshicht erforderliche Schicht (13, 14) aufgebracht und danach bei einer Temperatur von 900—950°C so lange (ca. 1 h) getempert, bis im Halbleiterkörper gemäß der Figur 11 die Halbleiterzonen 4 und 10 und damit die Übergange 5 und 9 entstehen und die Dotierfilme (2, 12) mit den sie bedeckenden Schichten (13, 14) gemäß der Figur 11 zu Antireflexschichten (6, 11) verschmelzen. Bei dem Temperprozeß werden die Antireflexschichten 6 und 11 leitend gemacht, so daß der Vorderseitenkontakt 7 und der Rückseitenkontakt 15 gemäß der Figur 12 unmittelbar auf die Antireflexschicht (6, 11) aufgebracht werden könne. Der Rückseitenkontakt 15 ist im Gegensatz zum Rückseitenkontakt 8 des ersten Ausführungsbeispiels in gleicher Weise ausgebildet wie der Vorderseitenkontakt 7, d. h. im allgemeinen fingerförmig.

Der $p^+p$-Übergang wirkt als rückseitiges Feld (*Back Surface Field*), wodurch sich die bekannten Vorteile einer BSF-Zelle wie erhöhte Leerlaufspannung und erhöhter Kurzschlußstrom durch verringerte Rekombination an der Rückseite ergeben. Die gezeigte Ausführung des Rückseitenkontaktes erlaubt auch die photovoltaische Umwandlung des rückseitig einfallenden Lichtes, während gleichzeitig die unerwünschte Wärmestrahlung die Zelle nahezu ungehindert durchdringen kann, ohne absorbiert zu werden, wodurch sich die Betriebstemperatur verringert.

Im Gegensatz zum Ausführungsbeispiel der Figuren 8—12 können der $pp^+$-Übergang und die leitfähige Antireflexschicht auf der Rückseite auch separat gebildet werden. Dabei wird vorzugsweise der Übergang jener Seite zuerst gebildet, bei dem die Temperung zur Bildung des Überganges und der leitfähigen Antireflexschicht bei einer höheren Temperatur bzw. bei einer längerum Zeit erfolgt, als auf der anderen Seite.

**Patentansprüche**

1. Verfahren zum Herstellen einer Solarzelle mit einem pn-Übergang und einer leitfähigen Antireflexschicht, bei dem der pn-Übergang durch Diffusion von Störstellen aus einer Dotierschicht hergestellt wird, bei dem auf einen Halbleiterkörper (1) eine erste Schicht (2) aufgebracht wird, die als Diffusionsquelle für die Herstellung des pn-Überganges sowie zur Dotierung der Antireflexschicht dient, bei dem auf die erste Schicht (2) eine zweite Schicht (3) für die Herstellung der Antireflexschicht aufgebracht wird, und bei dem ein Temperprozeß durchgeführt wird, bei dem der pn-Übergang hergestellt, aus den beiden Schichten die Antireflexschicht gebildet und die Antireflexschicht dotiert und dadurch gut leitfähig wird, dadurch gekennzeichent, daß die erste Schicht (2) aus dotiertem Siliciumdioxyd, Titanoxyd oder Tantaloxyd oder Kombinationen von diesen besteht und daß die zweite Schicht (3) aus Siliciumdioxyd, $TiO_x$ oder $Ta_2O_5$ oder Kombinationen von diesen besteht.

2. Verfahren nach Anspruch 1, dadurch gekennzeichnet, daß die erste Schicht (2) so dünn bemessen wird, daß eine möglichst gleichmäßig dicke Gesamt-Antireflexschicht (2, 3) entsteht.

3. Verfahren nach Anspruch 1 oder 2, dadurch gekennzeichnet, daß auf der Rückseite im Oberflächenbereich des Halbleiterkörpers (1) eine Halbleiterzone (10) vom Leitungstyp des Halbleiterkörpers (1) hergestellt wird, deren Leitfähigkeit größer ist als die des Halbleiterkörpers (1), und daß auf dieser Halbleiterzone (10) eine gut leitfähige Antireflexschicht (14) hergestellt wird.

4. Verfahren nach Anspruch 3, dadurch gekennzeichnet, daß auf die Rückseite des Halbleiterkörpers (1) eine dritte Schicht (12) aufgebracht wird, die als Diffusionsquelle zur Herstellung der Halbleiterzone (10) vom Leitungstyp des Halbleiterkörpers (1) sowie zur Dotierung der Antireflexschicht dient, daß auf die dritte Schicht (12) eine vierte Schicht (14) für die Herstellung der Antireflexschicht der Rückseite aufgebracht wird, und daß in dem Temperprozeß zur Herstellung des pn-Überganges und der Antireflexschicht der Vorderseite oder in einem gesonderten Temperprozeß auf der Rückseite der Solarzelle die Halbleiterzone (10) vom Leitungstyp des Halbleiterkörpers und aus der dritten (12) und der vierten Schicht (14) die leitfähige Antireflexschicht der Rückseite gebildet wird.

5. Verfahren nach einem der Ansprüche 1 bis 4, dadurch gekennzeichnet, daß die erste Schicht (2) und die dritte Schicht (12) durch Aufschleudern, Aufsprühen, Tauchen, Abscheidung, Siebdrucken oder durch Aufrollen aufgebracht werden.

6. Verfahren nach einem der Ansprüche 1 bis 5, dadurch gekennzeichnet, daß die zweite Schicht (3) und die vierte Schicht (14) durch Aufdampfen, chemisches Abscheiden aus der Gasphase oder durch Siebdrucken hergestellt werden.

7. Verfahren nach einem der Ansprüche 1 bis 6, dadurch gekennzeichnet, daß die zweite Schicht (3) und die vierte Schicht (14) so dick ausgebildet werden, daß die optische Gesamtdicke der ersten Schicht (2) und zweiten Schicht (3) sowie der dritten Schicht (12) und vierten Schicht (14) 1/4 der Wellenlänge des Reflexionsminimums beträgt.

## Revendications

1. Procédé de fabrication d'une cellule solaire présentant une jonction pn et une couche antireflet conductrice, procédé dans lequel on fabrique la jonction pn par diffusion d'impuretés à partir d'une couche dopante, dans lequel on rapporte sur un corps semi-conducteur (1) une première couche (2) qui sert de source de diffusion pour la fabrication de la jonction pn ainsi que pour le dopage de la couche antireflet, dans lequel on rapporte sur la première couche (2) une seconde couche (3) pour la fabrication de la couche antireflet, et dans lequel on procède à un processus chauffage au cours duquel la jonction pn se réalisé, la couche antireflet se forme à partir des deux couches et se dope et devient de ce fait bonne conductrice, caractérisé par le fait que la première couche (2) est constituée de dioxyde de silicium dopé, d'oxyde de titane dopé ou d'oxyde de tantale dopé, ou d'une combinaison de ces corps, et que la seconde couche (3) est constituée de $Ti_{ox}$ ou de $Ta_2O_5$ ou de combinaisons de ces corps.

2. Procédé selon la revendication 1, caractérisé par le fait que l'on dimensionne la première couche (2) suffisamment mince pour faire apparaître une couche antireflet totale (2, 3) d'une épaisseur la plus régulière possible.

3. Procédé selon la revendication 1 ou 2, caractérisé par le fait que sur la face arrière, sur la zone de surface du corps semi-conducteur (1), on fabrique une zone semi-conductrice (10) de conduction du type de celle du corps semi-conducteur (1), dont la conductivité est supérieure à celle du corps semi-conducteur (1), et par le fait que sur cette zone semi-conductrice (10) on fabrique une couche antireflet (14) bonne conductrice.

4. Procédé selon la revendication 3, caractérisé par le fait que sur la face arrière du corps semi-conducteur (1) on rapporte une troisième couche (12) qui sert de source de diffusion pour la fabrication de la zone semi-conductrice (10) de conduction du type de celle du corps semi-conducteur (1), que sur la troisième couche (12) on rapporte une quatrième couche (14) pour la fabrication de la couche antireflet de la face arrière, et que, dans le processus de chauffage pour la fabrication de la jonction pn et de la couche antireflet de la face avant, ou bien dans un processus de chauffage spécial sur la face arrière de la cellule solaire, on forme la zone semi-conductrice (10) de conduction du type de celle du corps semi-conducteur et qu'à partir de la troisième (12) et de la quatrième couche (14) on forme la couche antireflet conductrice de la face arrière.

5. Procédé selon l'une des revendications 1 à 4, caractérisé par le fait que l'on rapporte la première couche (2) et la troisième couche (12) par projection, pulvérisation, immersion, dépôt, sérigraphie ou par laminage.

6. Procédé selon l'une des revendications 1 à 5, caractérisé par le fait que l'on fabrique la seconde couche (3) et la quatrième couche (14) par métallisation en phase vapeur, dépôt chimique à partir de la phase vapeur ou par sérigraphie.

7. Procédé selon l'une des revendications 1 à 6, caractérisé par le fait que l'on prévoit la seconde couche (3) et la quatrième couche (14) suffisamment épaisses pour que l'épaisseur optique totale de la première couche (2) et de la seconde couche (3) ainsi que de la troisième couche (12) et de la quatrième couche (14) vaille 1/4 de la longueur d'onde du minimum de réflexion.

## Claims

1. Method for manufacturing a solar cell with a pn junction and a conductive antireflective layer, in which the pn junction is manufactured by the diffusion of impurities out of a doping layer, in which there is applied to a semi-conductor element (1) a first layer (2) which serves as diffusion source for the manufacture of the pn junction and for the doping of the antireflective layer, in which there is applied to the first layer (2) a second layer (3) for the manufacture of the antireflection layer, and in which an annealing process is carried out, in which the pn junction is manufactured, the antireflective layer is formed from the two layers and the antireflective layer is doped and thereby becomes highly conductive, characterized in that the first layer (2) consists of doped silicon dioxide, titanium oxide or tantalum oxide or combinations of these substances and that the second layer (3) consists of $TiO_x$ or $Ta_2O_5$ or combinations of these substances.

2. Method according to claim 1, charcterized in that the thinness of the first layer (2) is such that a total anti-reflective layer (2, 3) as uniformly thick as possible is obtained.

3. Method according to claim 1 or 2, characterized in that on the reverse side in the surface region of the semi-conductor element (1) a semi-conductor zone (10) of the same conduction type as the semi-conductor element (1) is manufactured, whose conductivity is greater than that of the semi-conductor element (1), and that on this semi-conductor zone (10) a highly conductive antireflective layer (14) is manufactured.

4. Method according to claim 3, characterized in that there is applied to the reverse side of the semi-conductor element (1) a third layer (12) which serves as a diffusion source for the manufacture of the semi-conductor zone (10) of the same conduction type as the semi-conductor element (1) and for the doping of the antireflective layer, that there is applied to the third layer (12) a fourth layer (14) for the manufacture of the antireflective layer of the reverse side, and that in the annealing process for the manufacture of the pn junction and of the antireflective layer of the front side or in a separate annealing process on the reverse side of the solar cell there is formed the semi-conductor zone (10) of the same conduction type as the semi-conductor element and, from the third (12) and the fourth layer (14), the conductive antireflective layer of the reverse side.

5. Method according to any one of claims 1 to 4, characterized in that the first layer (2) and the third layer (12) are applied by centrifuging, spraying, dipping, precipitation, screening or by rolling-on.

6. Method according to any one of claims 1 to 5, characterized in that the second layer (3) and the fourth layer (14) are manufactured by evaporation, chemical vapour deposition or by screening.

7. Method according to any one of claims 1 to 6, characterized in that the second layer (3) and the fourth layer (14) are designed so thick that the total optical thickness of the first layer (2) and second layer (3) and of the third layer (12) and fourth layer (14) comes to 1/4 of the wavelength of the reflection minimum.

FIG. 1

FIG. 2

FIG. 3

FIG. 4

FIG. 5

FIG. 6

FIG. 7

FIG. 8

FIG. 9

FIG. 10

**FIG. 11**

**FIG. 12**